# EUROPEAN PATENT APPLICATION

(11) **EP 2 659 987 A1**
(43) Date of publication of application: **06.11.2013**
(21) Application number: 13167735.3
(22) Date of filing: 26.03.2010
(51) Int. Cl.: B06B 1/00

(54) **Acoustic backing layer for use in an ultrasound transducer**

(30) Priority: 26.03.2009 GB 0905255; 26.03.2009 GB 0905256; 28.05.2009 GB 0909296
(62) Divisional of application: 10714943.7
(71) Applicant: Norwegian University of Science and Technology (NTNU), 7491 Trondheim (NO)
(72) Inventor: Berg, Sigrid, 7091 Tiller (NO); Chapagain, Kamal, 7491 Trondheim (NO); Due-Hansen, Jon, 2816 Gjovik (NO); Ingebrigtsen, Kjell Arne, 7033 Trondheim (NO); Jensen, Geir Uri, 0169 Oslo (NO); Midtbo, Kjersti, 1339 Voyenenga (NO); Poppe, Erik Utne, 1346 Gjettum (NO); Ronnekleiv, Arne, 7049 Trondheim (NO); Wang, Dag Thorstein, 0495 Oslo (NO)
(74) Representative: Jackson, Robert Patrick

(57) **Abstract**

An acoustic backing layer for use in an ultrasound transducer is arranged to scatter ultrasound waves of a plurality of distinct frequencies. The layer comprises a plurality of scattering structures that act independently of each other such that each creates a null in the specular wave reflection coefficient at a given frequency. The scattering structures are arranged such that they add 2*hᵢ* propagation length to signals reflected from half of the total area of any of the possible types of added propagation lengths due to the other propagation delays used. The scattering structures comprise: etched squares of different sizes; a pattern of two triangles which together form a square or a rectangle; parallel grooves which are overlaid on top of each other; or sets of periodic grooves in the same direction with different depths and widths, which are overlaid on one another such that the total depth in a given point is that which follows from the sum of all overlaid groove structures.

## Description

The present invention relates to a capacitive micro-machined ultrasound transducer (CMUT) array and, in particular, to an array that is suitable for use in a miniaturised imaging system. The invention also extends to a method of fabricating such an array.

Conventional ultrasound systems are based upon the use of piezoelectric elements. In order to provide an array of elements a piezoelectric material may be bonded to a printed circuit board and subsequently diced into separate elements. Connections to an integrated circuit are formed indirectly through a fan-out structure which has the disadvantage that it can degrade signal quality.

It will be appreciated that such a structure is difficult to scale down, as is necessary with high frequency applications where it is necessary to greatly reduce the distance between the elements. CMUT technology is a promising candidate for 2D ultrasound arrays that can be used to produce 3D images at high frequencies using miniature devices.

A single CMUT transducer element takes the form of a capacitor having a first rigid (bottom) electrode and a second (top) electrode formed of a membrane which deflects in response to the pressure from ultrasound waves when used as a receiver. Thus, the CMUT acts essentially as a condenser microphone. In a typical construction, the active acoustic part and top electrode of the CMUT capacitor is a metal-coated silicon nitride membrane whilst a heavily doped silicon substrate constitutes the bottom electrode. In use, DC bias is applied between the top and bottom electrodes which pulls the membrane towards the substrate due to electrostatic attraction. If an AC voltage is applied to the biased membrane, harmonic membrane motion is obtained and if a biased CMUT membrane is subject to an impinging ultrasonic pressure field, the membrane motion generates AC detection currents.

As their name implies, CMUTs are fabricated using micro-machining techniques, which are well known and involve processes such as the etching of silicon and silicon-based wafers, e.g. silicon buried oxide (BOX) wafers, and silicon wafers with various coatings, in order to produce desired mechanical structures. "Surface Micromachined Capacitive Ultrasonic Transducers" by Ladabaum et al, IEE Transactions on Ultrasonics, Ferroelectrics and Frequency Control, Vol 45, No 3, May 1998, describes an early technique. In this, the CMUT is formed from a single silicon wafer. An oxide layer is formed on the wafer and then a nitride layer is deposited. Apertures are then formed in the nitride layer by plasma etching and then areas of oxide are removed using hydrofluoric acid inserted through the apertures to form the cavities of the transducer. The apertures are then sealed by depositing a further layer of nitride ("cavity filling") and then a conductive metal layer is applied over the nitride to form a ground plane membrane.

A significant advance was the introduction of wafer bonding whereby a plurality of silicon wafers are bonded together in order to form a desired structure (see "Fabricating Capacitive Micromachined Ultrasonic Transducers with Wafer-Bonding Technology" by Huang et al JMEMS, 12 (2), 128 (2003)). This allowed a variety of new configurations for micro-machined structures. This paper shows that wafer bonding results in improved mechanical properties and the high quality membranes made by wafer bonding are superior to those obtainable by surface micromachining. For example, the cavity shape is independent of that of the membrane and the aspect ratio of the cavity is not restricted by the etching process; there are fewer limitations on device design; the membrane may be made of a single crystal and therefore has fewer internal defects and lower mechanical loss; and greater uniformity, stress controllability and process repeatability is possible.

A suitable bonding technique (fusion bonding) is described in "Fabrication and characterisation of CMUTs realised by wafer bonding" by K Midtbø, A Ronnekleiv and D T Wang, 2006 IEE Ultrasonics Symposium, which also describes a complete ultrasound transducer device using CMUTs which is formed using a stacked or layered structure in which the top layer is formed of a CMUT array structure, underneath which (taking the CMUT as the top, with the detector-surface uppermost) processing layers such as amplifiers, analogue to digital converters and multiplexing stages are provided. Finally, at the bottom of the stack, a backing layer of epoxy or similar material is provided which provides acoustic damping to the structure. Such a layer is necessary because otherwise waves transmitted and reflected inside the device would provide false signals which will be detected by the transducer and thereby significantly degrade performance.

The aim of CMUT technology is to enable ultrasound transducers to be miniaturised to such a degree as to enable imaging devices to be created that can be inserted into the human body for imaging purposes. In particular, catheter based intravenous ultrasound imaging systems have been proposed for use in examining plaque within arteries in order to distinguish whether the plaque is vulnerable or stable. (See "Self-biased charge sampling amplifier in 90 nm CMOS for medical ultrasound imaging" by L R Cenkeramaddi, T Singh and T Ytterdal, GLSVLSI'07, March 11-13 2007.

In order to provide such imaging devices having a useful resolution and to image a desired cone angle of around 90°, approximately 1000 transducer elements or more would be required in a device which must be of the order of a 1mm cube. As noted above, the usual construction is a stack of components with the CMUT array at the top and processing electronics beneath this. To provide the desired resolution the device should be operable at 20 to 50 MHz and preferably up to around 100 MHz. Such frequencies indicate that the CMUT array should be only around 20 µm in thickness.

A particular problem that is posed is to provide the necessary electrical interconnections between the individual transducer elements comprising the array and the associated electronics in the stack below which must process the output signals. This issue is further complicated by the fact that it is highly undesirable to have any exposed signal carrying conductor at the upper surface of the CMUT array. This surface forms the exterior of the device and will, in use, be in contact with bodily tissues and fluids. Therefore, this entire surface should be at ground potential both for reasons of safety and to prevent interference with signals. It would be undesirable to have to provide additional insulation layers on top of the CMUT membrane structure to isolate signal carrying conductors since this would both add to manufacturing complexity and also potentially degrade performance. However it may be necessary to add a layer to ensure biocompatibility.

US 2008/0048211 illustrates (in its prior art discussion) a CMUT structure formed using micromachining and wafer bonding. In this, a silicon layer forms the substrate of the device with CMUT cavities formed in an oxide layer thereon. The cavities are closed by a membrane layer formed of silicon oxide. A conductive bulk silicon layer beneath the cavities forms the back electrodes, with trenches formed in it to provide electrical isolation between the elements. This is known as a "a trench isolated" structure. However, whilst this is an effective technique from an electrical perspective, the trenches weaken the structure.

As discussed in "Wafer-Bonded 2-D CMUT Arrays Incorporating Through-Wafer Trench-Isolated Interconnects with a Supporting Frame" by Xuefeng Zhuang et al, IEEE Transactions on Ultrasonics, Ferroelectrics and Frequency Control, Vol 56, No 1, 1 January 2009, work has been carried out on the use of through-vias as an alternative to trench isolation. Here, a conductive material, usually doped polysilicon, is used to fill vias (passageways) through the substrate beneath the elements. There are particular problems in applying this approach to a wafer-bonded CMUT array; the via forming steps can cause problems with a subsequent bonding step and undesirable stresses can be caused to the wafer. This paper concludes that "To date, no successful through-via fabrication technique has been demonstrated that is compatible with the wafer-bonding technique of making CMUTs". Instead, it proposes an improved trench-isolation-based construction technique.

US 2008/0048211 (cited above) also states that the use of through-wafer vias is limited to *surface* micromachined (i.e. not wafer-bonded) CMUT structures. The invention described therein retrains the trench isolated structure but vias (which must be electrically isolated) are formed through the membrane itself.

Viewed from a first aspect, the present invention provides a wafer-bonded CMUT array comprising a plurality of CMUT elements distributed across a substrate, each element comprising a cavity and a signal electrode formed in the substrate, and a conductive membrane closing the cavity and forming a ground electrode, wherein the membranes of the individual elements form an unbroken ground plane across the surface of the array and wherein electrical connection to the signal electrodes is provided by means of a conductive vias depending therefrom through the substrate from the signal electrode to the rear of the substrate.

Thus, by means of the invention the known drawbacks of trench-isolated structures may be overcome. In particular, the elimination of isolation trenches removes a cause of weakness in prior art wafer bonded designs and so arrays according to the invention can be considerably more robust. Furthermore, the array of the invention has all of the advantages associated with a wafer-bonded structure.

In the discussion of the present invention, the same conventions regarding the orientation of the components are used as in the prior art discussion. Thus, the membrane forms an "upper" or "front" surface from which ultrasound waves are emitted and/or at which they are received and detected. The opposite side of the device is the "bottom" or "rear" or "back side". The conductive vias therefore pass downwardly from the signal (or "hot") electrode to the rear of the device, where control and/or signal processing electronics may be provided. The term "wafer-bonded" has its usual meaning in this art as set out above. Thus, the structure of the CMUT array is formed from a plurality of wafers which are bonded together.

Thus, by means of the present invention, a wafer-bonded (e.g. fusion bonded) CMUT array structure is provided which need not have trench vias and has a front surface that is free from conductors carrying signal voltages, whereby the front surface of the array itself can be maintained entirely at ground potential.

In order to provide the most compact structure, each via preferably depends directly downwards (i.e. away from the ground plane surface of the device) from an individual signal electrode. However, a plurality of transducers may be combined in a group of, say, four (or preferably more) to form what is effectively a single element. The electrodes of those individual transducers may be joined by conductors which may lie in the same plane as the electrodes and which are conveniently formed integrally therewith. Thus, a plurality of electrodes may form a contiguous conductive surface which may be connected to a single conductive via.

Preferably the electrodes are provided within the cavities. This is in contrast to the conventional prior art technique of where a layer of electrodes is provided below a separate structure in which the cavities are formed. For example, in conventional micromachined structures, a layer of oxide is formed over the electrode structure. Since the electrode structure is typically formed of polysilicon having significant surface roughness, this results in the oxide layer also being uneven. Whilst this can be tolerated in a surface micromachined device, such an uneven surface is unsuitable for wafer bonding. The inventors have recognised that by forming the electrodes within the cavities, the cavities may be formed in a wafer that forms the substrate and so the membrane structure may be bonded to the substrate wafer, rather than a grown oxide layer. This is an inherently more suitable surface to bond to as it can be chemically polished to leave a very smooth surface.

Although there are various approaches that may be taken towards micromachining the structure of the invention, the preferred approach is to create the substrate from silicon or silicon-based wafers. Silicon BOX wafers may be used in some embodiments since they have an oxide layer which is useful in the fabrication process.

The conducting vias and the cavity structure may be formed in a single wafer or the vias may be formed in one wafer and the cavity structure and signal electrode is formed in another wafer. In the latter case, an oxide layer may form an insulating layer between these two wafers.

The vias are most conveniently formed by etching bores in at least the silicon device layer of the wafer and inserting a conductive material therein. However, typically, an oxide layer will first have been created within the bore in order to insulate the via. The bores may be blind, in which case, after the portions of the wafer beneath the end of the bore (which may be used as a handle) has been removed, the vias will provide electrical communication from through the lower part of the substrate to the signal electrodes.

Within each element, the cavities of each individual transducer are preferably formed by partially etching away doped silicon to a predetermined depth. This depth (e.g. 50-70nm, preferably 60nm) may be such that a portion of doped silicon remains at the bottom of the cavity which may be used to form the signal electrode. Thus, the array may comprises a plurality of signal electrodes (or groups of such electrodes) comprising areas of doped silicon isolated by channels etched into the doped silicon.

Alternatively, a deeper cavity may be formed and the signal electrodes may be formed of polysilicon which is deposited in the cavities. It is preferably doped with phosphorous. The cavity gap may be tuned by etching the polysilicon, which forms the base of the cavity, to the desired height specified above.

Since the structure is wafer-bonded, the membrane is formed using a further, typically silicon-based, wafer. In the embodiments described herein, the membrane is formed from a silicon wafer coated with silicon nitride and optionally also silicon oxide which is bonded to the wafer that forms the cavity structure. The membrane is then formed by etching away down to a single layer of silicon nitride layer and of silicon oxide if appropriate, at least in the region overlying the transducer elements.

As noted above, the elements are completed by a ground plane electrode layer which is formed over the membranes across the surface of the individual elements (this may be regarded as forming a single conductive ground plane membrane surface). A portion of the wafer from which the membrane is formed may be left intact in order to form an upstand around the periphery of the device.

Most preferably, ground electrodes are provided at the periphery in order to provide a sound electrical connection to the membrane itself. Since these electrodes are at ground potential, the problems described above concerning exposed signal electrodes do not arise. The membrane is preferably made electrically conductive by providing a metallic layer/film thereon. This may comprise aluminium, titanium or tungsten and is formed by, for example, a sputtering process.

If desired, conductive vias as described above may additionally be provided to provide a third electrical connection to the CMUT. This may be used to separate the DC bias voltage from the RF voltages.

An additional electrode may also be used to electrically tune the CMUT resonance frequency and coupling factor. Releasing the energy stored on a separate electrode in the CMUT array can also be used to generate a transmit pulse and thus separate the transmit signals from the receive signals.

The invention also extends to a method of creating the type of transducer array generally described above. Thus viewed from another aspect, the present invention provides a method of fabricating a CMUT array having a plurality of CMUT elements distributed across a substrate, the method comprising:
in the silicon substrate, forming a cavity and a signal electrode for each element and conductive vias providing electrical connection to the electrodes, the conductive vias being arranged to depend from the elements; and
providing a conductive membrane to close each cavity and form a ground electrode, whereby an unbroken ground plane is formed across the surface of the CMUT array; wherein the conductive membrane is formed from a silicon wafer that is bonded to the substrate.

Thus, a wafer-bonded CMUT array having through vias may be formed. As discussed above, the membrane provides an unbroken ground plane across the surface of the elements (i.e. in use it is connected to ground potential and the surface of the membrane is at this common potential). Electrical connection may be provided to the membrane by providing contacts thereon, preferably at the periphery of the device.

The cavities and the vias are preferably formed in a substrate comprising a single (first) silicon wafer with the membrane being formed in a further (second) wafer in a manner as described above.

In this method, preferably the vias are formed before the cavities; thus, the first silicon wafer may be provided and bores etched therein which will form vias in the completed structure. Subsequently, cavities may be formed in the first wafer. The cavities and the bores may be insulated by growing an oxide layer over their surfaces. Conductive material, such as polysilicon may be used to form the conductors within the bores and electrodes within the cavities; this may be done simultaneously to form a contiguous conductive member (i.e. via and connected electrode(s)).

As noted above, the electrodes are preferably formed within the cavities, most preferably extending to form the bases of the cavities, as opposed to underneath a layer in which the cavities are formed. Thus, the method preferably comprises forming cavities in the substrate prior to forming the electrodes therein (though as noted above, in one embodiment the cavity may be etched down to silicon which is then used to form the electrode).

Prefereably the upper surface of the substrate is polished flat prior to bonding with the membrane-forming wafer.

As discussed above, the conductive membrane may comprises a separate silicon wafer, which is preferably nitride coated. It is preferably bonded to the substrate after the electrodes have been formed but before the vias are completed. The via-forming bores preferably are not etched right through the wafer, in which case the vias are therefore preferably completed by removing a portion of the back side of the substrate to expose the conductor within the bores.

By means of the preferred features of the method, the bonding step is undertaken as late as possible to avoid stresses to the membrane. Most preferably, the bonding step takes place after the vias have been formed and after the surface of the substrate to which the membrane will be bonded is polished flat The membrane may then be formed from the second wafer by etching away material to leave the membrane layer in the known manner. The conductive ground plane may then be applied, as may the necessary electrical contacts.

Embodiments of the invention will be described subsequently and the method preferably further includes appropriate features thereof.

The concept of forming the electrodes within the cavities of a CMUT array is also believed to be inventive and therefore, viewed from a further aspect, there is provided a CMUT array comprising: a substrate with cavities formed therein, the cavities containing electrodes; and a conductive membrane arranged over the cavities arranged to close the cavities. There are preferably further provided vias depending from the electrodes though the substrate to provide signal connections, with the membrane forming a common electrode. The array preferably comprises the preferred features of other aspects of the invention.

Viewed from a still further aspect, the invention provides a method of fabricating a CMUT array comprising: forming an array of conductive vias and an array of cavity structures in a first silicon-based wafer; providing a further silicon wafer and forming therefrom a conductive membrane; wherein the wafers are each micro-machined to form their respective structures and are bonded together to form the array such that the membrane extends across the cavities, a signal electrode is provided in each cavity, and each via provides electrical connection to a signal electrode formed in a cavity structure.

In an alternative approach, the substrate may be formed from a plurality of wafers. One wafer may be used to form the cavities and another the vias. These are preferably bonded together before the membrane wafer is bonded. Thus, viewed from another aspect there is provided a method of fabricating a CMUT array comprising providing: a first silicon wafer and forming therein an array of conductive vias; a second silicon wafer and forming therein an array of cavity structures; and a third silicon wafer and forming therefrom a conductive membrane; wherein the wafers are each micro-machined to form their respective structures and are bonded together to form the array such that the membrane extends across the cavities, a signal electrode is provided in each cavity, and each via provides electrical connection to a signal electrode formed in a cavity structure.

In this approach, it is most preferred, that the cavity structure and wafer and via array wafer are formed from silicon wafers and the membrane is preferably formed from nitride-coated wafer.

Usually the via structure will be created first by etching a plurality of bores through the device layer of the respective wafer. The (second) wafer that forms the cavity structure can then be placed upon the first wafer in an "inverted" configuration such that the device layers of the two wafers are adjacent. However, it is preferred that before this is done an oxide layer is provided on the device layer of the first wafer. After the two wafers have been bonded, the "handle" layer of silicon can be removed from the second wafer.

Preferably, once this has been done the silicon device layer of the second wafer may be doped and the cavity structure etched therein. This will preferably form a large number of isolated lands. Most preferably the process further involves etching away a portion of each isolated structure in order to provide a cavity having beneath it a portion of doped silicon which forms the signal electrode. Typically around 60 nm of doped silicon will be etched in order to provide a cavity of this depth.

The next step preferably involves placing the third (membrane forming) wafer on top of the structure such that a silicon nitride layer is located above the cavities as described previously. It is then possible to form a membrane by etching away silicon from the wafer to leave behind the nitride layer which forms the basis of the membrane. Whilst the silicon should be etched away above the array of transducers, a portion of the array may be left in place around the periphery of the device in order to provide an upstand. The membrane may be completed as discussed above.

At some point in the process, the handle silicon layer of the first wafer is removed. This is preferably done after the third (membrane) wafer has been applied because this provides significant mechanical strength to the structure. It is then possible to insert conductive material into the bores in order to form vias.

Thus, it will be seen that a highly convenient method is provided for forming a CMUT array which is free from non-grounded electrical conductors on its front surface.

Although the invention has been described in the context of a wafer bonded structure, it is believed that the inventive concepts described herein may be applied to non-wafer bonded structures. Thus viewed from a still further aspect, the present invention provides a CMUT array comprising: a plurality of CMUT elements distributed across a substrate, each element comprising a cavity and a signal electrode formed in the substrate, and a conductive membrane closing the cavity and forming a ground electrode, wherein the membranes of the individual elements form an unbroken ground plane across the surface of the array and wherein electrical connection to the signal electrodes is provided by means of a conductive vias depending therefrom through the substrate from the signal electrode to the rear of the substrate. Most preferably, the electrodes are formed within the cavities as described above.

As discussed previously, the CMUT array of the invention is intended for use as part of an integrated ultrasound transducer package comprising signal processing layers arranged beneath the CMUT array layer. In such a structure, the electrical signals from each transducer preferably pass vertically through the device in parallel to each other (and are processed in parallel) through various stages such as analogue to digital converters, amplifiers, etc. at least until they reach a signal processors stage where they may be multiplexed. Normally an acoustic backing layer which provides damping, as is well known in the art, is provided at the rear face of the device.

The inventors have, however, discovered that the acoustic properties of the device can be improved if a further acoustic damping layer is provided between the CMUT array and the processing structure. It is particularly preferred for this layer to be provided directly adjacent the CMUT array, whereby electrical connections are provided through this further acoustic layer to the signal processing circuitry.

This arrangement is believed in itself to represent a further invention and therefore, viewed from a further aspect, the present invention provides an integrated CMUT structure comprising a CMUT array, signal processing circuitry and a first acoustic layer, wherein the signal processing circuitry is provided between the CMUT layer and the first acoustic layer and wherein a further acoustic layer is provided between the CMUT array and the signal processing structure. Preferably, as described above, the second acoustic layer is provided directly adjacent the CMUT array layer. The invention also extends to a method of producing such an array.

Another invention described herein relates to the acoustic backing layer for a CMUT device, such as the one discussed above. As noted above, an acoustic backing layer is provided in CMUT devices. This ensures that any acoustic signal which propagates from the transducer into the backing is absorbed in the backing such that it does not excite the transducer in a way that gives a false echo in the signal received by the transducer (in reception), or transmitted from the transducer (in transmission). If it not is absorbed it could also be modified in such a way that it does not interfere with signals the transducer is set up to receive or transmit at the moment. This will in most cases mean that the waves are shifted in propagation direction.

Given the need to produce these devices in such small packages, in many cases there is little space available under the transducer such that it is difficult to accommodate a sufficiently thick layer of material with high propagation losses, to ensure that no signal is reflected back to the transducer.

The conventional approach to this problem has been to provide irregular structures of the bottom surface which to scatter the waves, but they also take up some space and are not an optimum solution to this problem.

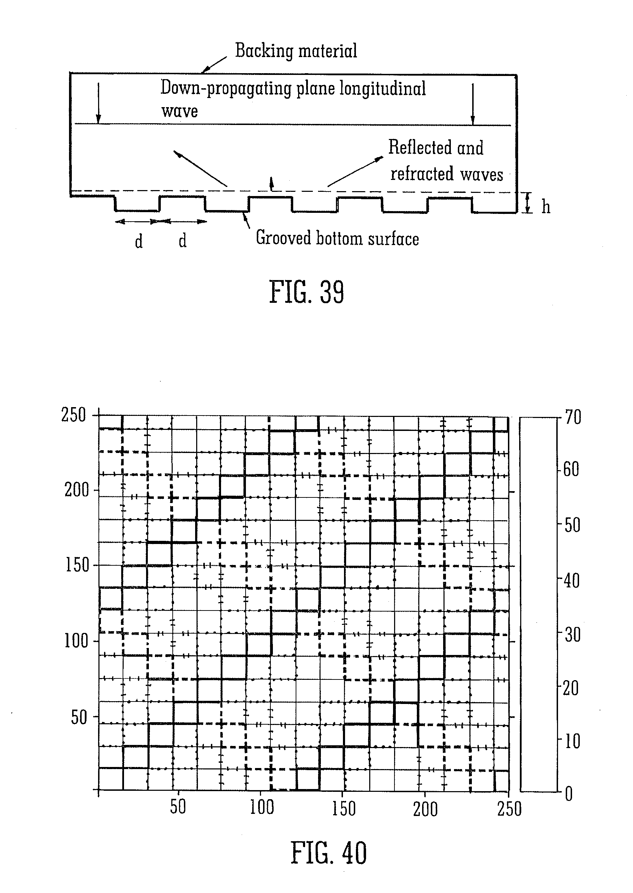

In US 7231181 there is proposed a backing layer in which regularly shaped, one-quarter-wavelength deep grooves are formed on the base or upper surface of the layer. This results in what is effectively a diffraction grating being formed. Half of the waves passing down through the layer are reflected from the bottom surface of the backing layer and half are reflected from the grooved portions, with the effect that the waves become 180 degrees out of phase with each other and undergo destructive interference. This principle is described in more detail below in relation to Figure 39.

Whilst this approach is effective, it is inherently tuned to a specific wavelength and therefore its effectiveness is somewhat limited.

According to the invention there is provided an acoustic backing layer for use in an ultrasound transducer, the layer being arranged to scatter ultrasound waves of a plurality of distinct frequencies, wherein the backing layer comprises a plurality of scattering structures that act independently of each other such that each creates a null in the specular wave reflection coefficient at a given frequency.

The term "acoustic backing layer" as used herein means a layer which is provided in order to suppress ultrasonic waves, for example to prevent bulk waves from propagating, or at least to attenuate them.

Thus, by means of the present invention a backing layer is provided that can be compact in size whilst also being able to scatter a range of frequencies of ultrasound waves.

Typically, the scattering structures are arranged such that they add 2*hᵢ* propagation length to signals reflected from half of the total area of any of the possible types of added propagation lengths due to the other propagation delays used. (A recess of depth *h* in the base of the layer will result in a reflected wave having propagation path that is 2*h* shorter than the path of wave reflected off the base of the layer thus, if *h* is one quarter of a wavelength, waves that have travelled the shorter path will destructively interfere with those that have travelled the longer path). This balance in propagation delays should preferably be maintained both globally, over the complete structure, but also locally, for smaller areas everywhere in the structure.

One structure which is capable of doing this comprises etched squares of different sizes, where the squares of each size are organized as on a checker board, and, say the black checker board squares are etched down a certain height *hᵢ* for the *i*-th checker board. To accommodate three heights in the balanced way described above the size of the squares in the checkerboards may be scaled such that there is a linear factor of at least two in size between them (two to an integer power). Thus, four squares of the smaller pattern may be placed in one of the next larger squares and so on. Larger squares should preferably give cancellation at lower frequencies through choice of the height difference.

The present invention therefore provides a systematic way to make the back surface scatter the waves into waves with significantly changed propagation directions, often giving long propagation paths back to the transducer. Hence they will only to a small degree affect the imaging done with the transducer, if they should reach back to the transducer. It may also convert the waves to shear waves in the backing, which normally have much higher propagation losses in the backing material than the incoming longitudinal wave and hence also reduce chance for the wave energy to reach the transducer with significant strength. The structure takes little space, as its total depth at the bottom of the backing material is on the order of one wavelength.

The checkerboard arrangement is one of many ways to make a scattering structure for use in the invention. It is also possible to use parallel grooves which have the same distance between grooves as the groove width. Several groove structures may be overlaid on top of each other such that they are all active at the same time, and balanced as described above. It is also possible to use different directions for grooves with different depth and possibly also different width which are designed to make them active at desired frequencies. Three structures of grooves could have grove directions that differ by 45 degrees and 90 degrees internally. Another approach is to provide sets of periodic grooves in the same direction with different depths and widths, which are overlaid on one another. This may be done so the total depth in a given point is that which follows from the sum of all overlaid groove structures. In this case there should be an integer relationship between the periods of the different groove structures, to fulfil the local balance principle.

Another possible structure has a basic pattern of two triangles which together form a square or a rectangle. A structure which forms a balanced depth pattern combined with this could be the structure which is obtained if the square or rectangle is divided into triangles by the other of the two possible diagonals. To include more patterns one could repeat the same structure with rectangles where the dimensions in the plane are scaled up or down a factor of two.

In the discussion above, cases where the edges of topography of the surface structuring are sharp have been considered. However, structures with more gradual edges will perform as well, and may be easier to fabricate by casting. The acoustic layer may be formed of any suitable material, for example epoxy and tungsten which is suitable for moulding.

Although the invention is primarily envisaged as a backing layer, in other aspects of the invention a layer of the type described may be provided elsewhere in the structure of an ultrasound transducer (especially a CMUT). For example, it may be necessary to desirable to provide a backing layer between the CMUT array and its associated signal processing and control electronic circuitry. The structures of the present invention may be used in either or both such backing layers. Indeed, the provision of an integrated ultrasound transducer apparatus having a first damping layer between the CMUT array and the associated signal processing and control electronic circuitry within the apparatus provides a further aspect of this invention. The structures of the invention may also be applied to other fields where sonic or ultrasonic waves need to be absorbed or attenuated.

The invention is useful with any type of ultrasound transducer that employs an acoustic backing layer, but it is particularly useful for CMUT structures. Thus, viewed from another aspect the invention provides a CMUT device comprising an acoustic layer as described above.

The invention also extends to a method of fabricating an acoustic backing layer comprising forming such a structure thereon, e.g. by moulding, micro-machining (including etching, photolithography), etc., and to a method of constructing a CMUT device comprising such a layer.

As noted above, the provision of a backing layer comprising acoustic damping material is well known in CMUT devices. It is also set out above that the inventors have discovered that the acoustic properties can be improved if a further damping layer is provided between the CMUT layer and the signal processing structure, particularly if it is provided directly adjacent to the CMUT layer.

However, it is inherent in the use of such a damping layer in the type of array described that electrical connections (known in this field as "vias") must be provided through it, from the CMUT layer above to the signal processing structure below and this is the subject of a further invention. The inventors have recognised that known techniques for fabricating such vias result in a structure that is too stiff to function optimally as a damping layer. For example, the vias may be created by etching away semiconductor wafer to leave a set of conductors ("poles") surrounded by voids that are subsequently filled with damping material. However, known etching techniques, such as deep reactive ion etching (DRIE), place a lower limit on the pole diameter of 10 microns for a damping layer thickness of 100 microns. If the poles are located at, say, a 25 micron pitch in both transverse directions, the poles will dominate the stiffness of the plate in terms of vertical compression, thereby significantly reducing the damping properties of the layer.

According to the present invention there is provided an acoustic damping structure for use in an ultrasound transducer, the damping structure comprising a layer of acoustic damping material having an upper surface and a lower surface and a plurality of electrical conductors extending from the upper surface through the layer of acoustic damping material to the lower surface, wherein the conductors each meet the lower surface of the damping structure at positions that are laterally offset from the positions at which they meet the upper surface.

Thus, by means of the invention the conductors (vias) do not form direct vertical paths (like columns) from the upper to the lower surface and therefore provide significantly less vertical rigidity to the structure.

The invention may be provided by the use of substantially straight conductors arranged at a significant angle relative to the upper and lower surfaces (i.e. not perpendicular thereto) , in other words, the conductors may run diagonally. However, such a structure is not straightforward to construct and does not provide the optimal acoustic properties. It is therefore preferred that the conductors are not straight but rather follow paths with bend(s). A particularly preferred arrangement is for the conductors to be cranked. Thus, the conductors may have a first portion extending from the upper surface into the acoustic damping layer, a second portion offset therefrom and extending from the lower surface into the acoustic damping layer, and a third portion extending within the acoustic damping layer from the first portion to the second portion.

Although other forms are possible, the damping layer is typically of generally planar form, with the upper and lower surfaces being substantially parallel. It is most convenient for the first and second portions of the conductors to be substantially perpendicular to the upper and lower surfaces, i.e. for them to generally vertical if the upper and lower surfaces are taken as a horizontal reference. In addition, the third portions are preferably generally parallel to the upper and lower surfaces (i.e. horizontal). This enables the third portions to be deposited as a horizontal layer during construction of the damping structure.

The vertical parts of the conductors are preferably formed, as described above, by etching away a semiconductor (e.g. silicon) wafer to leave poles. Most preferably, the damping layer is formed from a plurality of layers, most simply from two layers of half the final thickness. This provides the further advantage that the diameter of the poles may be reduced to half the thickness, e.g. 5 microns compared to 10 microns in the example above.

The two layers may then be connected together such that the positions of the poles in each part are offset. For example, if the poles form the corners of a grid in the first layer those in the second layer would be located at the centres of the same grid in the second layer. In the above example, a 25 micron grid spacing is suitable. This arrangement is regarded as being a further inventive concept and so, viewed from a further aspect it provides an acoustic damping structure for use in an ultrasound transducer, the damping layer comprising at least two adjacent damping layer portions each having electrical conductors passing therethrough, wherein the electrical conductors of one layer portion are each connected to an electrical connector in the other layer portion by a transverse conductor disposed at the boundary between the layers.

The two layers could be connected by using a (preferably thin) layer of anisotropically conducting glue. Such glue has a rather low density of conducting spheres which gives conduction between two conducting surfaces as the surfaces are squeezed together in the gluing process, but which does not give conduction transversely in the layer of glue.

It will be appreciated that more layers can be used if required. Thus, three layers may be used together with two sets of horizontal conductive portions, and so on. In such arrangements, only the a poles of adjacent layer portions need be offset from each other. Indeed, the invention may be further viewed as an acoustic damping structure for use in an ultrasound transducer, wherein vias are formed through a damping layer, the vias following paths with bends therein and preferably comprising portions that are perpendicular to the direction of the remainder of the via.

A convenient way to construct each layer is to use silicon BOX (buried oxide layer) wafers with the poles being created in the device layer, preferably extending from the surface to the BOX. The back side of the wafer is then used as a handle during processing.

The poles may then be surrounded with acoustic damping material, such as epoxy containing tungsten particles and then the horizontal conductive portions may be created on the epoxy surface of one of the wafers before the two wafers are bonded together such that the horizontal conductive portions form electrical connections between the two sets of offset poles.

One of the handle layers may then be removed to enable one set of poles to be connected to other components in an ultrasound transducer structure, for example the CMUT array. Once that has been done, it is possible to remove the remaining handle layer, thereby exposing the other set of poles for connection to, for example, the signal processing layers in order to form an ultrasound transducer structure. Thus, the acoustic damping layer of the invention is intended for use as part of an integrated ultrasound transducer package comprising signal processing layers arranged beneath the CMUT array layer. In such a structure, the electrical signals from each transducer preferably pass vertically through the device in parallel to each other (and are processed in parallel) through various stages such as analogue to digital converters, amplifiers, etc. at least until they are reach a signal processors stage where they may be multiplexed. Normally an acoustic backing layer which provides damping, as is well known in the art, is provided at the rear face of the device. That layer may also be formed according the present invention if electrical vias are required therein.

Although the invention has been described in the context of CMUT devices, it is applicable to other ultrasound transducers. Indeed, it may be used on other fields where a similar acoustic damping structure is required.

The invention also extends to corresponding methods of producing acoustic damping layers, thus, viewed from a still further aspect the invention provides a method of constructing an acoustic damping structure for use in an ultrasound transducer, comprising forming a plurality of electrically conducting poles surrounded by a void on first and second wafers, surrounding the conducting poles with acoustic damping material, providing electrically conductive paths in electrical connection with the poles on the surface of one of the wafers and bonding the wafers together such that the poles of one wafer are each laterally off-set from the poles of the other wafer and such that each pole of the first wafer is connected to a pole of the second wafer via one of the conductive paths.

The invention also extends to a (preferably invasive) ultrasound imaging system comprising a transducer as previously described incorporating such acoustic damping layer(s) and to a method of imaging using a transducer according to the invention. In a practical system, signals from such a transducer, preferably having been multiplexed, are transmitted via signal leads to a processing system to an image display device. Control circuitry may also be provided in order to control the beam, etc. as is known generally in the field of ultrasound.

The CMUT arrays of the invention may be produced in the form of a "robot pill", i.e. in a self-contained form that may be swallowed by a patient. Thus, viewed from a further aspect the invention provides a swallowable ultrasound transducer comprising a CMUT array according to any other aspect of the invention. The robot pill preferably includes a source of power and is preferably provided with a sealed enclosure to protect the array against body fluids (stomach acid, etc.). It may comprise a data recording system, such as a processor and memory unit, but in a particularly preferred form it comprises a transmitter (e.g. radio transmitter) to transmit images to an external receiver.

Each of the inventions discussed above also extends to a (preferably invasive) ultrasound imaging system comprising a transducer as previously described and to a method of imaging using a transducer according to the invention(s). In a practical system, signals from such a transducer, preferably having been multiplexed, are transmitted via signal leads to a processing system to an image display device. Control circuitry may also be provided in order to control the beam, etc. as is known generally in the field of ultrasound. Embodiment of the inventions will now be described, by way of example only, with reference to the accompanying drawings:
Figure 1 is a schematic perspective view of an ultrasound transducer assembly incorporating a CMUT array which is an embodiment of the invention;
Figure 2 is a schematic cross-section of three silicon wafers used in the construction of the array;
Figure 3 is a schematic sectional view of a first of the silicon wafers illustrating the formation of a bore therein;
Figure 4 is a view corresponding to Figure 3 showing the result of further processing steps;
Figure 5 is a schematic sectional view corresponding to Figure 4, showing the addition of a second of the wafers to the structure;
Figures 6 and 7 are schematic sectional views corresponding to Figure 5, showing the result of further sequential processing steps;
Figure 8 a schematic sectional view corresponding to Figure 7, showing the addition of a third of the wafers to the structure;
Figures 9 and 10 are schematic sectional views corresponding to Figure 8, showing the result of further processing steps;
Figure 11 is a sectional view of the completed CMUT;
Figure 12A is a partial sectional view through an array of the CMUTs and Figure 12A is a partial plan view corresponding to Figure 12A illustrating the section line used;
Figures 13A and 13B correspond to Figures 12A and 12B but employing a different section line;
Figure 14 is a cross sectional view of a CMUT array according to another embodiment of the invention;
Figures 15 and 16 are views of the array of Figure 14 which correspond to Figures 12B and 13B showing the cross-sectional lines used in Figures 17 and 18;
Figures 17 and 18are sectional views of the array of Figure 15 along lines A-A and B-B of Figures 15 and 16 respectively;
Figures 19 and 20 correspond to Figures 15 and 16 but shows a slightly simplified structure;
Figure 21 shows schematic cross-sectional views of silicon wafers used in the manufacture of the embodiment of Figure 14;
Figures 22(a) and (b) to 35(a) and (b) and Figure 37(a) and (b) are cross sectional views along the lines A-A and B-B defined by Figures 19 and 20 showing consecutive steps in the manufacture of the array according to the embodiment of Figure 14;
Figures 36 and 38 are schematic views corresponding to Figure 14 showing the final stages in the manufacture of the array according to the embodiment of Figure 14;
Figure 39 is a schematic diagram of a prior art backing layer;
Figure 40 is a contour plot (in plan view) of the base of a backing layer according to an embodiment of the present invention;
Figure 41 is a graph illustrating the reflection loss from the backing layer of Figure 40 as a function of frequency;
Figure 42 is a schematic sectional view of a BOX wafer used in the construction of a damping layer according to a further embodiment in which silicon has been etched away to leave conducting poles;
Figure 43 is a view of the wafer of Figure 42 where a layer of damping material has been added to surround the poles;
Figure 44 is a schematic plan view of conductive tracks formed on the upper surface of the wafer of Figure 43; and

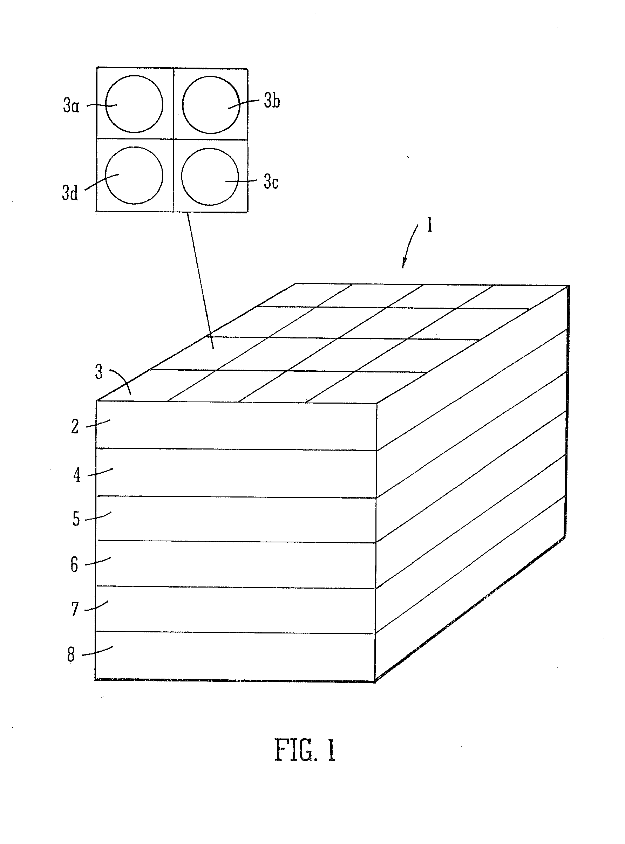

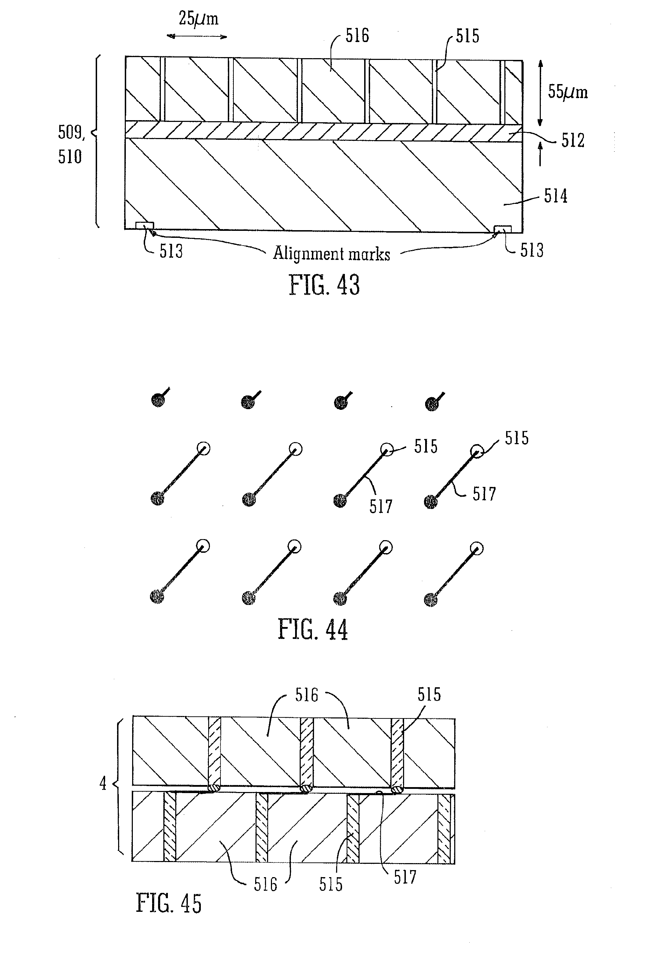

Figure 45 is a schematic sectional view of the completed embodiment. With reference to Figure 1, an ultrasound transducer assembly is illustrated. It is suitable for use in invasive ultrasound procedures, i.e., it may be used in an ultrasound "camera" that can be mounted on tip of catheter or needle for insertion into blood vessels, etc. Such a device needs to be able to scan a large field of view so a large number of elements must be provided in the array. The embodiment may be used to image a cone with angle of 90 degrees, and so around 1000 elements are provided in package of about 1mm cubed.

The assembly 1 is formed from a number of separately-formed layers that form a stack. At the top (as shown) is the CMUT layer 2 that comprises an array of transducer elements 3. Each of these elements actually comprises four individual transducers 3a-3d, as will be described below. (In other embodiments this number could be different, in most cases higher.) To provide the necessary resolution, the embodiment operates at ultrasound frequencies of 20-50 MHz; the layer is a 20 micron thick micro-machined silicon structure. Its construction will be discussed in detail below.

The remaining layers are disposed beneath the CMUT layer 2. In general, these layers comprise multiple elements that correspond to the CMUT elements such that the signal paths to and from each CMUT are parallel and vertical (as illustrated) through the structure.

Beneath CMUT layer 2 is an acoustic layer 4 which serves to provide acoustic isolation of the transducers from the remainder of the device. Since the top layer of the device is almost pure silicon, this layer is provided to prevent the propagation of surface waves. A surface wave is a wave that propagates across the surface of the transducer. If surface waves were allowed to propagate then they would destroy the operation of the device, at least within a certain range of angles. (In prior art devices, isolation trenches are provided to reduce propagation of waves, but these are not employed in the present embodiment.) The acoustic layer 2 is formed of epoxy resin and tungsten beads and is 100 microns in thickness.

The next layer is the high voltage transmitting layer 5. This provides the necessary drive voltages to each of the transducers in order to cause them to emit ultrasound waves. This layer provides drive voltages in the +/- 10 to 15 volt range (these are "high voltages" in the present context). It also enables the transmitted pulse to be steered in a desired direction, which is done by exciting each of the different elements in a predetermined sequence, as is known generally in the field of ultrasound transducers. This layer may also be controlled so that only a part of the array is used when transmitting,

In the described embodiment, the same elements are used for transmission and reception, however, in other embodiments (not illustrated), separate transmit and receive elements are provided.

Receiving layer 6 receives signals from the transducers and pre-processes them before they are transmitted to the signal processing and communications layer 7. In particular, layer 6 contains analogue-to-digital converters arranged to convert the output from each transducer into digital form. Layer 7 then processes and multiplexes the digital signals so that they can be transmitted along a small number of conductors to a display device. Thus, it has inputs corresponding to each CMUT element, but has a much smaller number of outputs to provide an image signal from the device.

Thus, in the embodiment, as well as the CMUT elements being used in both receive and transmit modes, the receive and transmit electronics is provided within one unified structure. However, in simpler embodiments (not illustrated) the transmitter may be placed on a separate chip from the receiver and not necessarily co-aligned with the receive and beam former stack.

The final layer 8 is a further acoustic damping layer which prevents bulk waves from propagating. Such layers are conventional in conventional transducers based on piezoelectric materials. However, the use of two acoustic layers (4 and 8) is original in this design. In conventional piezoelectric ultrasound devices the transducer part is much thicker and there is no sandwich of Silicon between two damping layers and so the single layer of damping layer at the base of the structure (i.e. layer 8) was sufficient to damp the surface waves. However, this has been found to be ineffective when there are Silicon layers between it and the transducer, as in the described embodiment.

An important feature of the device is that there are no non-grounded electrical connections to or through the front (top as shown) of the device; the live connections are provided only via the rear (bottom as shown) of the CMUT elements, as will be described in more detail below. This enables the front of the device to be grounded and so no "live" signal carrying conductors are exposed on the exterior of the device. This has safety considerations where high drive voltages are involved and poses problems in electrically isolating signal carrying conductors.

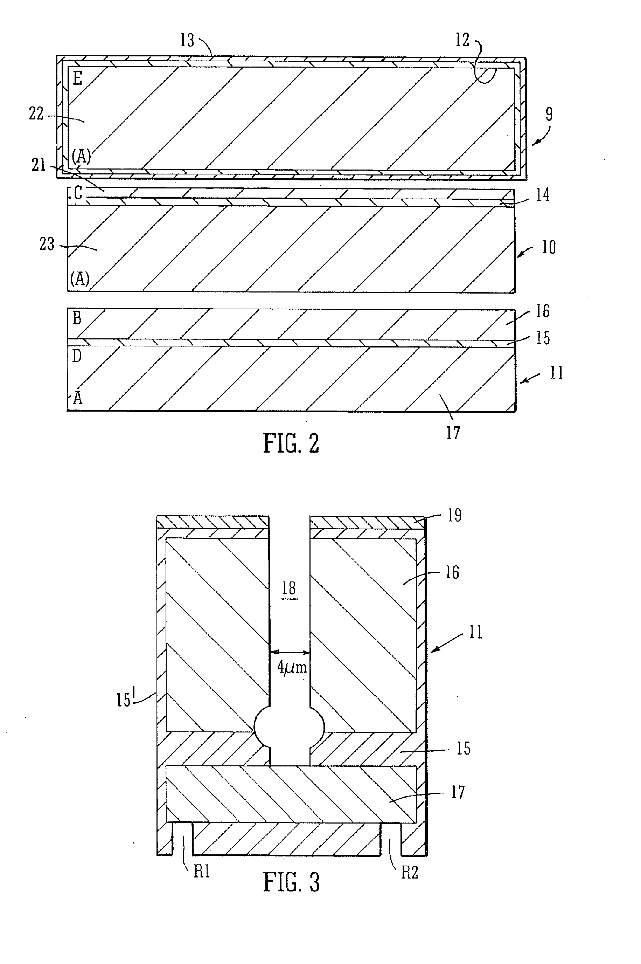

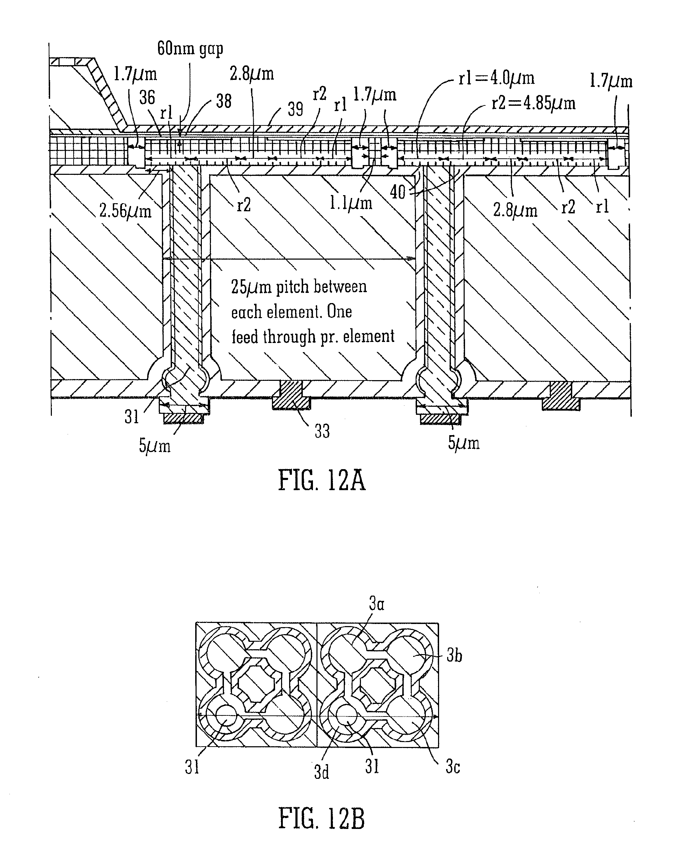

The process for fabricating the CMUT layer 2 of the device will now be described, with reference to the remaining figures. It should be noted that whereas Figure 2 shows silicon wafers from which an array of CMUT transducer elements are formed, and Figures 12A to 13B show (parts of) complete arrays, for reasons of clarity, Figures 2 to 11 illustrate the formation of only a single CMUT element of four transducers 3a-3d. The figures are purely schematic and not to scale; in addition, Figures 3-11 are somewhat foreshortened in the horizontal direction compared to Figures 2 and 12A-13B in order to enable details to be clearly seen.

The CMUT layer 2 is formed from three separate silicon wafers 9, 10 and 11, as shown in Figure 2. The first wafer 9 is a silicon wafer coated with an oxide (SiO₂) layer 12 and, on top of the oxide layer, a 100nm nitride (Si₃N₄) layer 13. This will be used in the construction of the CMUT's membrane. The second and third layers 10, 11 are regular Si BOX wafers, i.e. they each have a layer of oxide 14, 15 sandwiched within them. (The Oxide layer is normally used to reduce capacitance between neighbouring circuits on the surface of an integrated circuit.) Wafer 10 has an 8 micron device layer 21 and a 0.3 micron BOX layer 14; for wafer 11, these thicknesses are 10 microns and 2 microns respectively. The handle layers 23 and 17 (and also layer 22 of wafer 11 which is also a handle) are significantly thicker, though this dimension is not critical. As will be described, much of each of these wafers will be etched away during the micro-machining process.

In the completed CMUT array, the bottom wafer 11 forms the main silicon structure on which the transducer elements are carried and in which the vias forming electrical connections are formed. The middle layer 10 forms the CMUT cavity structure and the top layer 9 is used to create the membrane. The wafers are shown in their "normal" way up - with their device layers of wafers 10 and 11 where electronic circuitry is formed - on the top. Note that middle wafer 10 will be inverted in the following process.

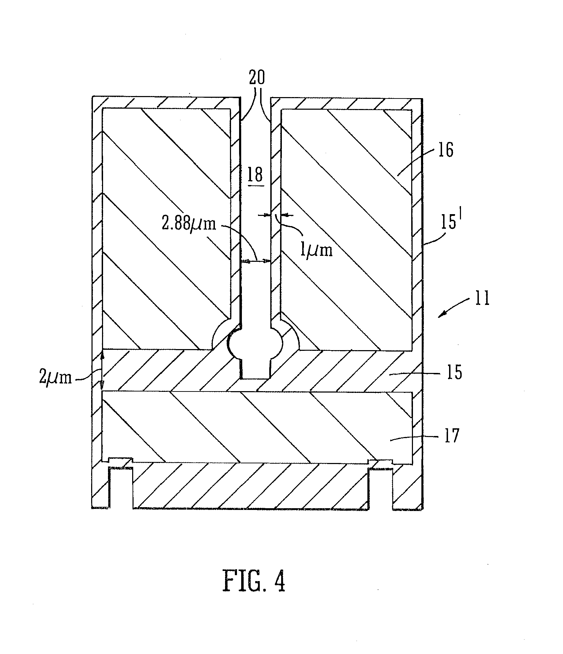

The first micro-machining stage is shown in Fig 3. This shows wafer 11 which has undergone an oxidising process to provide an oxide layer 15' around its sides. After that, a 4 micron diameter bore 18 is etched down through the top silicon layer 16 and through the oxide 15. This bore will eventually be used to form a conducting via. Etching the top part of newly created oxide layer 15' and through the silicon 16 is done by reactive ion etching (RIE) (oxide layer 15') and deep reactive ion etching (DRIE) (silicon layer 16), with the hole through the oxide layer 15 having been done using HF etch. In this process, photoresist material 19 is applied to the upper surface to form a mask, though the top oxide layer 15' acts as part of the masking in the DRIE process. It is not important if the bottom silicon layer 17 is etched to some degree because this is going to be removed later. In addition, registration markers R1 and R2 are formed in the oxide layer 15' for aligning this wafer with the corresponding markers on the other wafers in subsequent bonding processes. Although not discussed further in the following discussion, these markers are etched as part of the first processing step for each of the wafers to ease the alignment of the wafers in the bonding process. It is important that the crystal orientation of the wafers match well to obtain a good bonding Next, the photoresist which controlled where the etching took place is removed and a 1 micron oxide layer 20 is applied to the inside of the bore 18 - see Figure 4. This forms an insulating layer for the via.

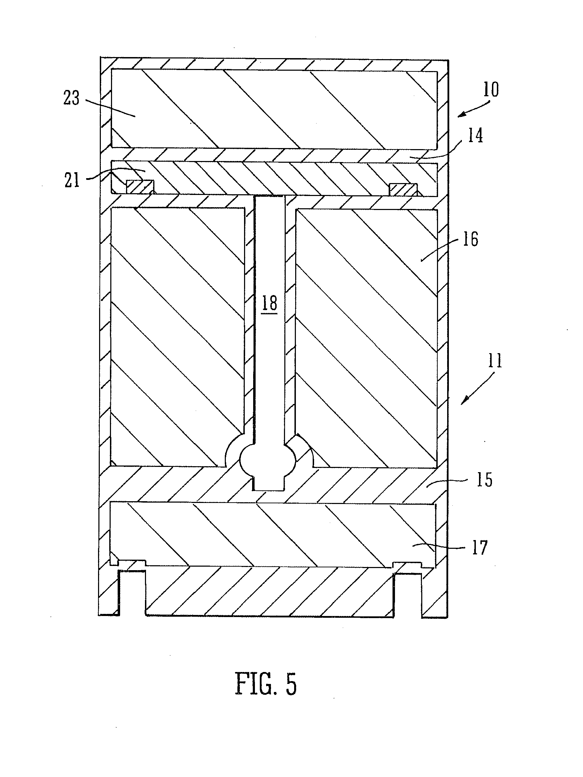

In the next stage, the middle wafer 10 is employed. As can be seen from Figure 5, it is inverted (compared to the view in Figure 2) and placed on top of the bottom wafer 11. In order to form a sound bond, the surfaces of the wafers are cleaned and hydrophilised, aligned, pressed together, and are then heated, in the conventional fashion.

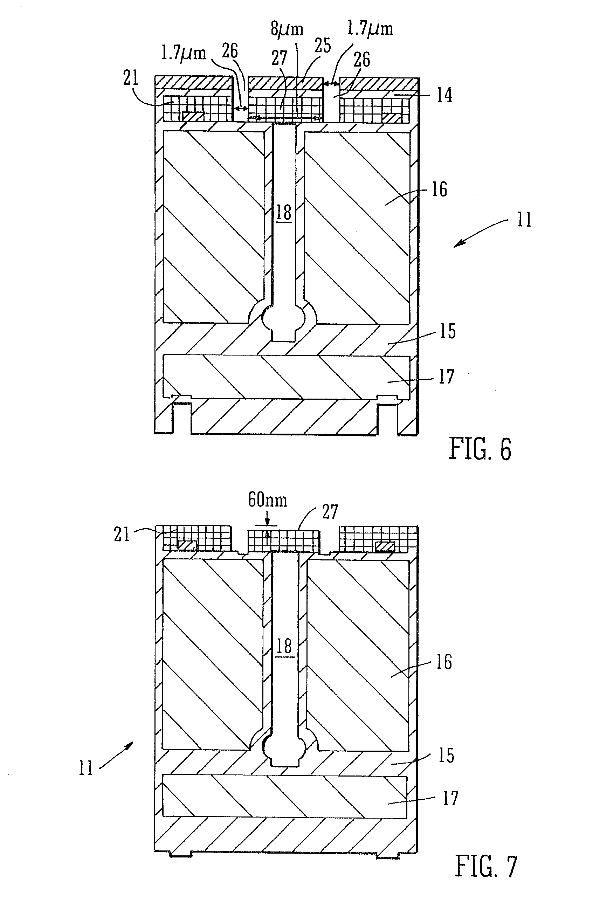

The next step (see Figure 6) is to etch away from wafer 10 the top layer (as now shown) 23 which has acted as a "handle" for the structure. (Its only function was to provide a support for the remaining oxide layer and Si layers which are very thin).

Once this has been done, the oxide layer is removed and the silicon layer 21 is doped with POCl₃ to give it a high concentration of phosphor at the surface. This leaves a residue on the surface called phosphor glass, which should be removed, hence the following steps are carried out: etch off phosphor glass; grow a thin oxide layer; high temperature for long time treatment of wafer to allow phosphor to diffuse into device layer to obtain phosphor concentrations of the order of 10¹⁶/cm³ to 10¹⁹/cm³; etch away oxide; grow a new oxide, 500 nm thick.

Next, a mask of photoresist 25 is applied to the oxide layer 14 and channels 26 are etched using reactive ion etching (RIE) and deep reactive ion etching (DRIE) into the oxide layer 14 and the doped silicon layer 21. These channels will form the outlines of the individual transducer elements 3a-3d.

Next, (see Figure 7), the photoresist 25 is removed along with the oxide layer 22. Then, a new layer of photoresist is applied (to define a new area for etching) and the central portion 27 (see Figures 6 and 7) of the upper part of the structure is etched down by 60nm to form what will be the inside of the CMUT cavity. It is necessary to etch this part in a very controlled manner. This is done knowing that silicon oxidizes with different speed depending on the thickness of the oxide, and that the silicon needed to form the oxide is taken from the oxidized surface. The process is then as follows: oxidize the whole surface uniformly (500 nm); Protect the surface which shall stand up with photo resist; etch away the oxide in the areas to be recessed; remove the photo resist; oxidize again for a suitable time; remove all oxide. This leaves the structure shown in Figure 7.

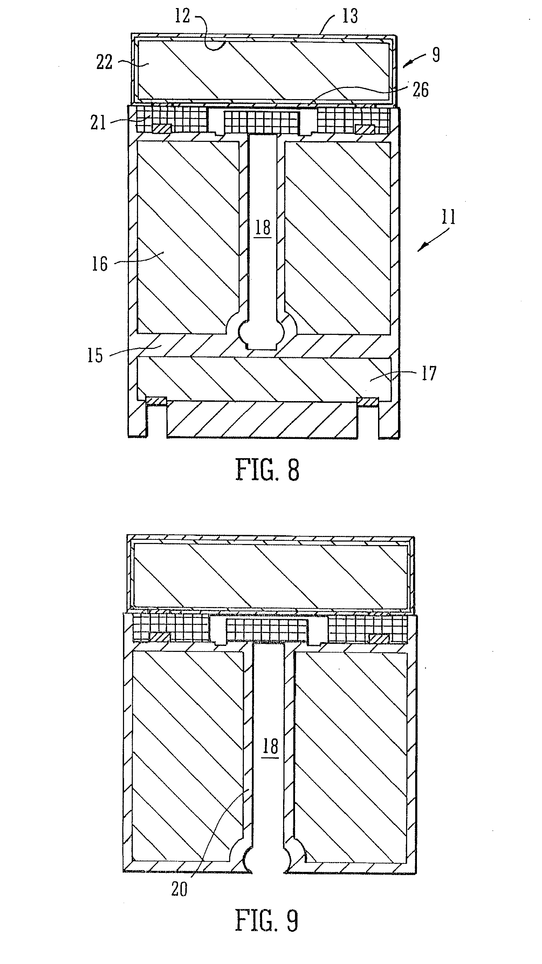

Turning now to Figure 8, the third and final wafer 9 is placed on top of the structure after having been cleaned, hydrophilised and then the wafers are aligned using the registration markers R1, R2, etc., and bonded together. The lower part of the nitride layer 26 of this wafer will form part of the membrane that closes the CMUT cavities.

Now that there is a strong wafer 9 on the top of the structure which provides mechanical strength, it is possible to remove the bottom "handle" layer of silicon 17 by first using RIE to remove the oxide. Then layer 15 is etched away by tetra methyl ammonium hydroxide TMAH. In addition, part of oxide along with the oxide formed at the base of bore 18 is etched away by RIE to form the structure shown in Figure 9 in which the bottom of bore 18 has been opened.

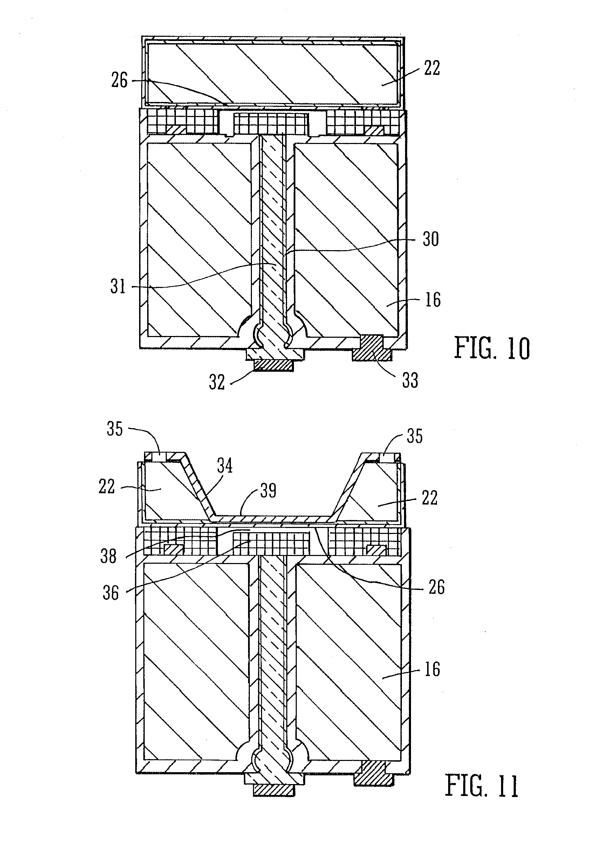

The next stage is to form a via by injecting conductive material into bore 18. As shown in Figure 10 - first a layer of polysilicon (amorphous polycrystalline silicon) 30 is provided to line the bore. This is then heavily doped and then more polysilicon 31 is used to fill up the bore 18. Excess polysilicon remaining on the bottom of the structure is then removed and an aluminium contact 32 applied by sputtering. A further aluminium contact 33 is applied (into an etched bore) to provide connection to the bulk of the Silicon.

Turning to Figure 11, the next step is to TMAH etch away silicon layer 22 (and its covering layers) over the CMUT element down to nitride layer 28. Note that outer regions of layer 22 are kept to provide an upstand around the upper part of the structure to allow easy handling in testing. Although the present description shows a single element, as shown in later figures, the silicon layer 22 is etched away over all of the array of CMUTs with the upstand remaining around the periphery of the complete device. In another embodiment of the invention a bottom damping layer 8, provides the handling strength for the structure of the array and so the upstand is not required.

Next, 100nm of conducting film, e.g. aluminium or titanium or tungsten or combination thereof film 39 is deposited and a 150nm silicon nitride layer 34 is formed on top of it using plasma enhanced vapour deposition. This creates the membrane of the CMUT. The nitride layer provides strength to the membranes and protects the conducting film, which in turn provides a conductive "capacitor plate". Finally, holes are etched into the periphery of the device and gold contacts 35 are inserted to provide ground connections. The aluminium film forms a common ground plane so only a few of these electrodes are needed around the periphery of the whole array.

Thus, in the completed CMUT, the aluminium-containing membrane (39 etc.) forms one (grounded) plate of the capacitive element, and portion 36 of the doped silicon layer 21 forms the live/signal plate. These two plates are parallel to each other and are separated by a cavity 38. Electrical connection to the grounded membrane is by way of contacts 35 and connection to the live plate 36 is by way of the via 32 that extends downwards through the silicon layer directly beneath it.

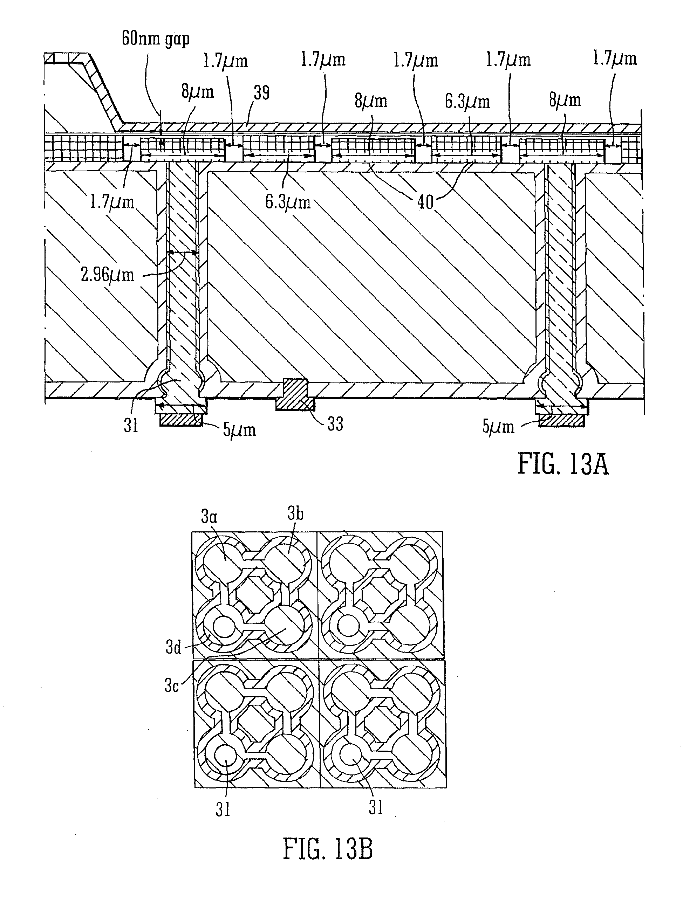

As noted above, the complete embodiment contains around 1000 elements each comprising four 4 individual transducers 3a-3d as shown in Figures 12A to 13B. Figures 12B and 13B show most clearly the layout of elements 3 which each contain four individual transducers 3a-3d. Figures 12A and 13A show how adjacent elements and their respective vias 31 are arranged in relation to each other. It will be noted that that each element of four transducers has only one via and that the signal electrodes of each of the four individual transducers are connected together. This can best be seen in Figures 12B and 13B. The central parts of each transducer are, as previously described, etched down by 60nm to form the bottom cavity in the CMUTs, and in addition the outer 0.85 micrometers of the narrow "lines" that connect the circles. The remaining voids 40 that can be seen in Figures 12A and 13A are the registration markers.

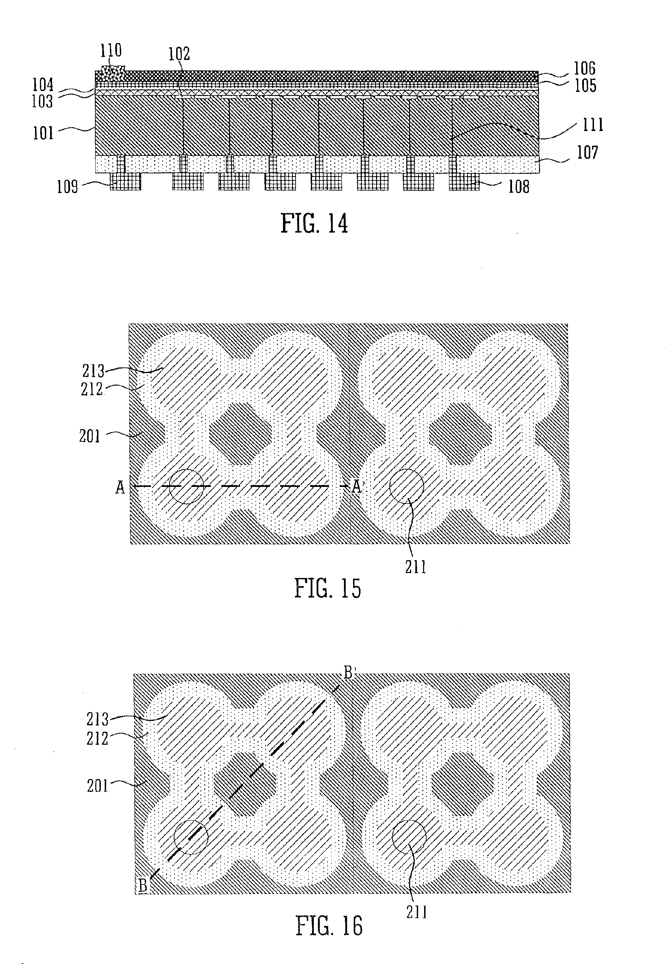

A further embodiment of the invention, together with its method of production will now be described with reference to figures 14 to 38. The embodiment is similar in its overall structure to that described above, but the cavities are formed in the same piece of silicon wafer as the vias.

Figure 14 shows a cross section of the embodiment showing an array of vacuum sealed CMUT cavities or cells 102 with uniform grounded top electrode 106 and electrical via connections 111 ('vias') to the back side where electrical contacts 108 are provided. The bulk silicon substrate has a separate electrical contact 109. The membrane stack over the CMUT cells consists of LPCVD silicon nitride (103), silicon oxide 104, metal layer 105 and a PECVD (Plasma Enhanced Chemical Vapour Deposition) silicon nitride layer 106. The gold contact 110 is deposited to provide for electrical connection to the membrane stack metal layer 105 which constitutes the top electrode.

The CMUT array, part of which is shown in Figure 14, consists of thousands of elements where each element consists of four circular CMUT cells 102. Figures 15 and 16 show top view sketches of two CMUT elements before fusion bonding of the membrane stack. The surface of the bulk silicon wafer 201 constitutes the area for fusion bonding of silicon nitride 103 to silicon 201, as will be discussed more fully below. The small circles 211 in one of the cells in each element in Figures 15 and 16 illustrate where the electrical via connection 111 from Figure 1 is located. The doped polysilicon 213 forms the bottom electrodes and interconnection lines between the CMUT cells which connect the four CMUT cells electrically together to form one element. The polysilicon surface 213 defines the bottom of the cavity. The trenches of silicon oxide 212 provide isolation between the elements and define the diameter of both the bottom electrode area and the circular membranes.

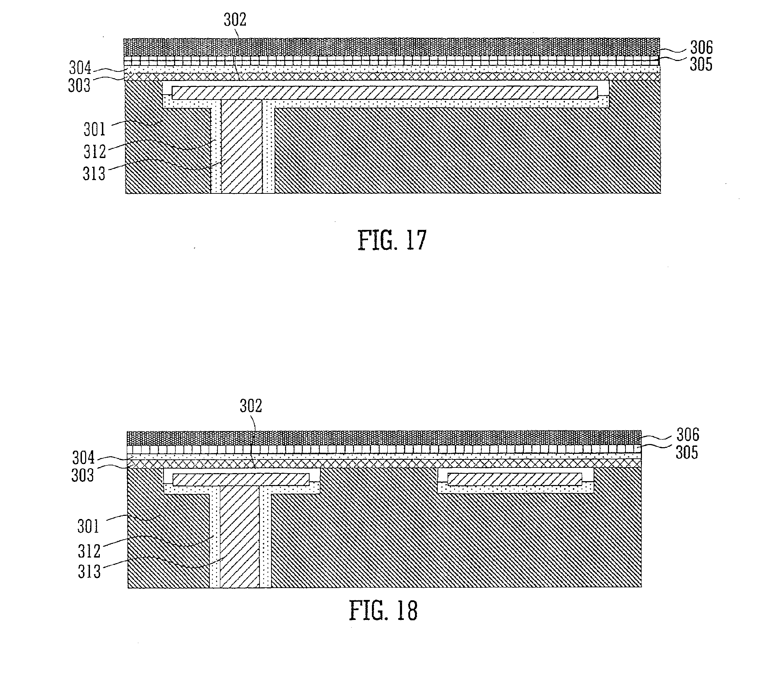

Figures 15 and 16 are provided with cross-section lines which define the sectional views used in the subsequent two figures. Figure 15 shows the cross section A-A' through one element used in Figure 17. Similarly B-B' in Figure 16 shows the cross section diagonally through one element used in Figure 18.

As may be seen from Figures 17 and 18, LPCVD (Low Pressure Chemical Vapour Deposition) silicon nitride 303 with silicon oxide 304 on top thereof is fusion bonded to the bulk silicon surface 301. The membrane stack suspended over the vacuum-sealed CMUT cell 302 is completed by a thin metal layer 305, and a PECVD silicon nitride layer 306. Doped poly silicon 313 constitutes the bottom electrode and electrical via connections to the back side of the component. Silicon oxide 312 isolates between the via connections and defines the diameter of both the bottom electrode area and the circular membranes.

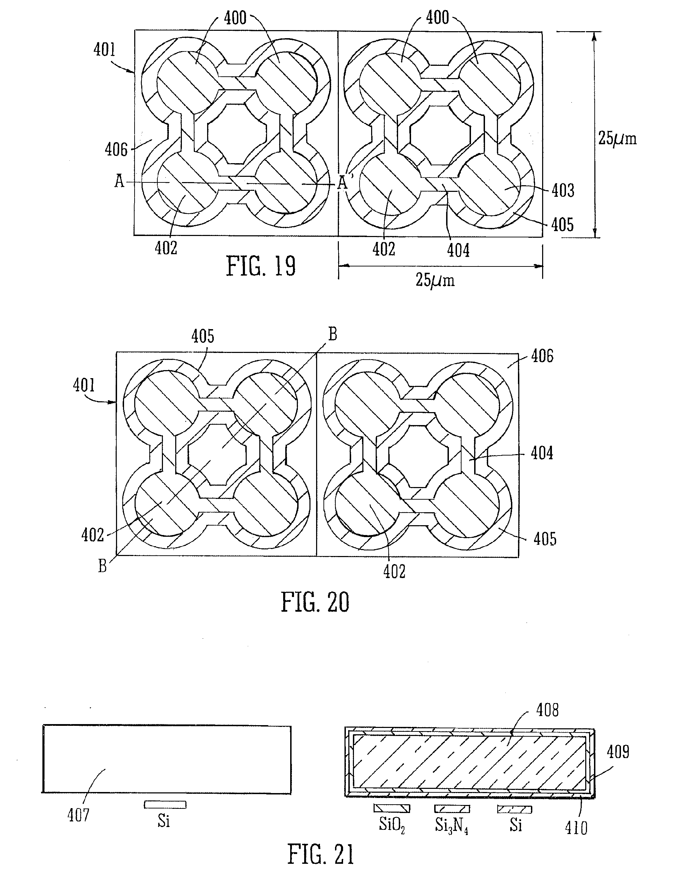

The process for manufacturing this embodiment will now be described in a step-by-step manner with reference to figures 19 to 38. Figures 19 and 20 correspond to Figures 15 and 16, but for clarity show a simplified (single-path) interconnection between the cells 400 making up each element 401; the subsequent figures correspond to this arrangement and show the cross sections A-A (left-to-right) and B-B (diagonal) defined by these figures.

As before, the small circle 402 in one of the cells in each element shows the top of the electrical via connection. The grey-dotted areas 403 are the doped polysilicon bottom electrodes with interconnection lines 404 between the CMUT cells which electrically connect the four CMUT cells to one element. The polysilicon surface defines the bottom of the cavity. The surrounding areas 405 indicate silicon oxide trenches. These trenches isolate between the elements and define the diameter of both the bottom electrode area and the circular membranes. The outer area 406 shows the bare silicon wafer. This is the bond surface for fusion bonding to the membrane-forming wafer.

Figure 21 shows the wafers used in the process. At the left it shows a standard silicon wafer 407 in which the CMUT elements and via connections will be formed. On the right it shows a standard silicon wafer 408 with a thin layer of silicon oxide 409 surrounding it. Low Pressure Chemical Vapour Deposited (LPCVD) silicon nitride 410 is deposited on top to form the outermost layer. This wafer will be fusion bonded to the bare silicon wafer.

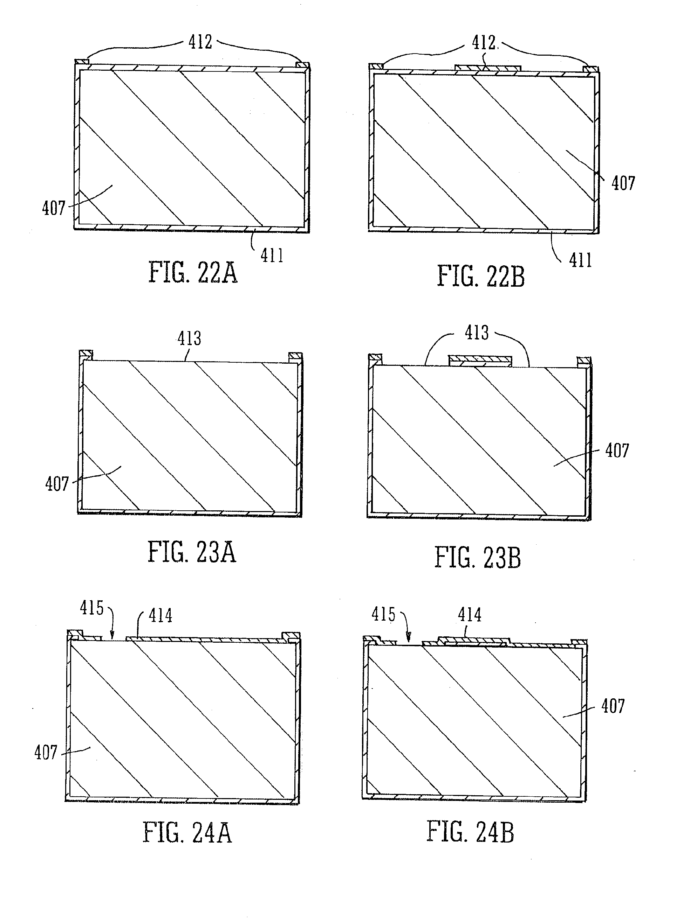

In the following figures, the left-hand "(a)" part shows the cross-section A-A of Figure 15; the right-hand "(b)" Figure shows the cross-section B-B of Figure 16. The pairs of figures will be described together by use of the number alone; thus "Figure 22" refers to both Figures 22(a) and 22(b).

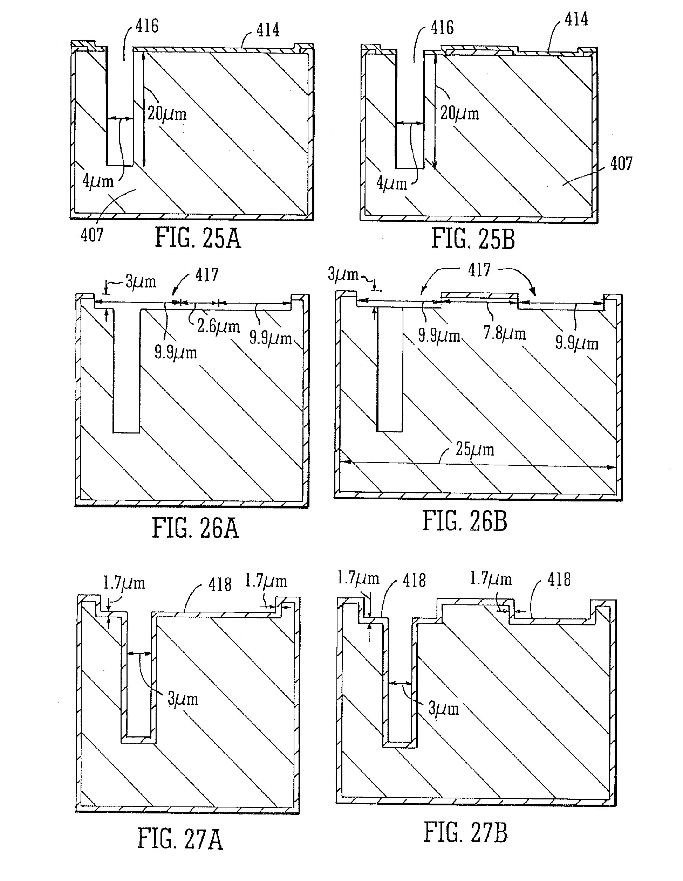

The process sequence starts with the standard silicon wafer. Figure 22 shows that the wafer 407 is wet oxidized to apply a layer of silicon oxide 411 before a layer of photo resist 412 is patterned. After patterning the photo resist, the silicon oxide 411 is etched by Reactive Ione Etching (RIE), with the result shown in Figure 23 where parts 413 of the upper surface of the silicon are exposed. The remaining oxide layer will be used later as an oxide mask for defining the element areas, see Figure 26. Figure 24 shows a second resist mask 414 for defining the location 415 of the via connections.

20 µm deep holes 416 are then etched at locations 415 into the wafer by Deep Reactive Ione Etching (DRIE) as shown in Figure 25. The diameter of the vias is about 4 µm.

The next stage is that the photo resist 414 is removed and the areas for the elements 417 are defined by RIE, see Figure 26.

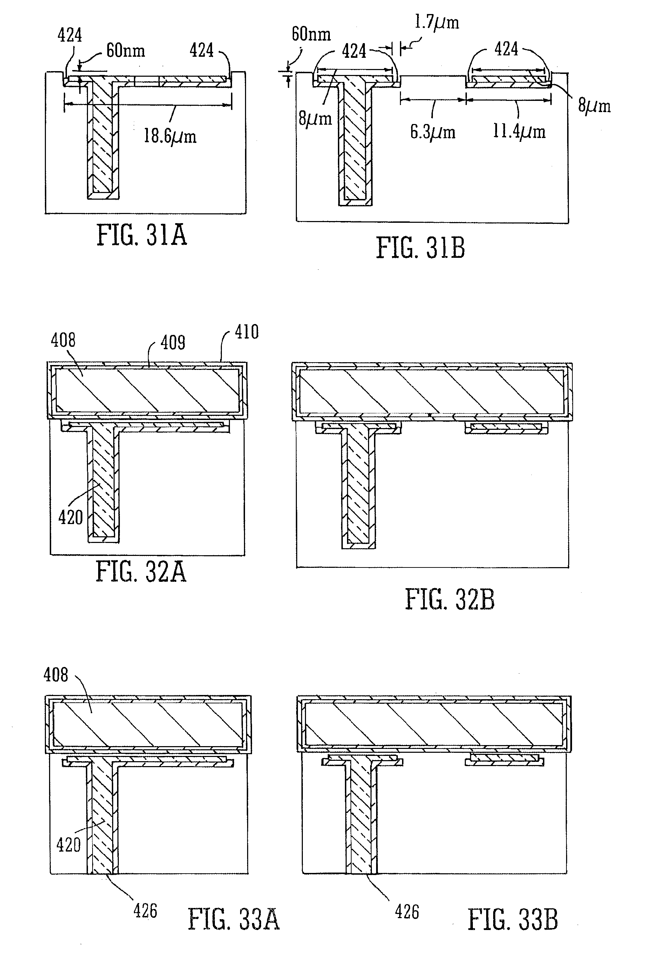

The wafer is wet oxidized by a thick silicon oxide 418, see Figure 27. This provides an insulating layer that will serve to isolate the vias from each other. In addition, the silicon oxide will constitute isolation trenches between the elements and define the diameter of both the bottom electrode and membrane (see Figure 31 below).

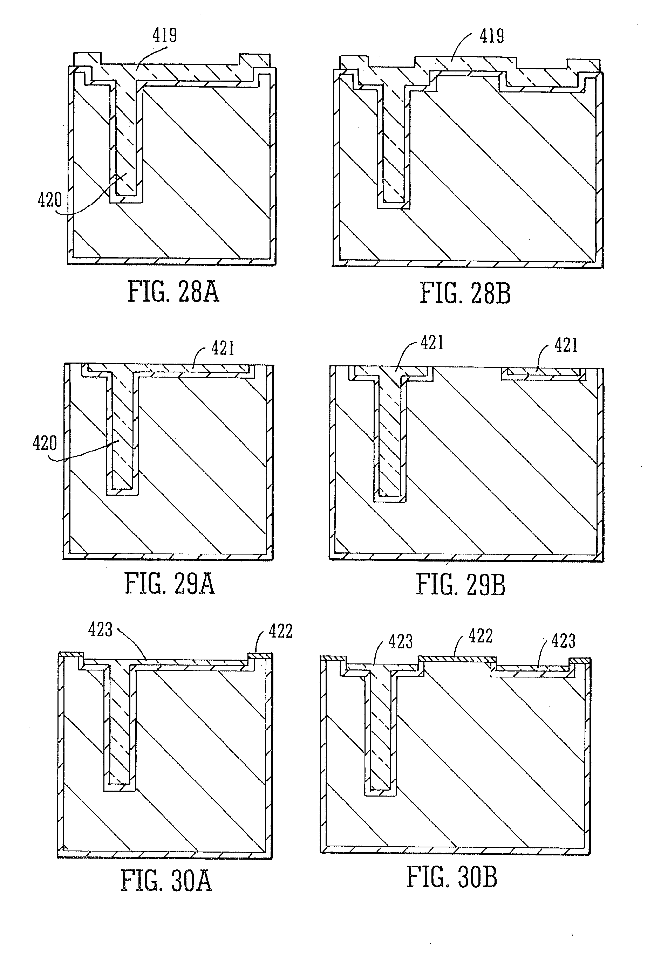

The vias are filled by poly silicon 419 (Figure 28) which is doped by phosphorus. This forms conductors 420 through the vias which are contiguous with material which will form the element signal electrodes. As shown in Figure 29, the next step is for the upper part of the wafer to be removed and polished by Chemical Mechanical Polishing (CMP), which defines the electrodes 421.

The wafer is patterned by photo resist 422 and the cavity gap 423 is tuned by etching about 60 nm of the poly silicon by RIE (Figure 30). The isolation trenches 424 are then created by etching away 200-300 nm of the silicon oxide using BuHF (Figure 31). This completes the formation of the lower part of the cells and so the wafer shown in the right hand part of Figure 21 may then be fusion bonded to the upper part, as shown in Figure 32, to close the cells.

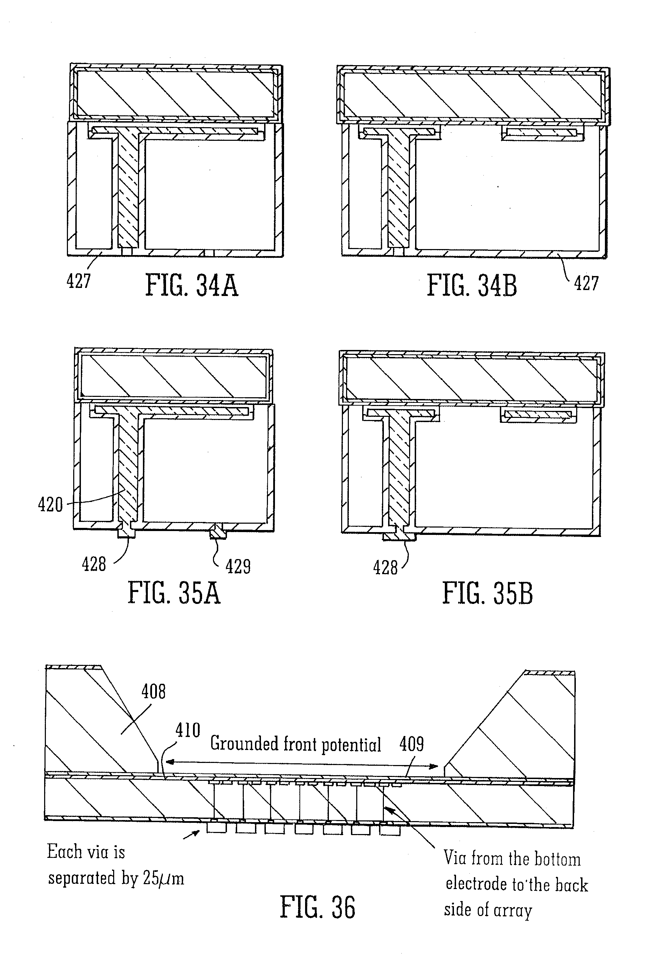

When that has been done, the back side (lower part as shown) of the bottom wafer is thinned using tetramethylammonium hydroxide (TMAH) and RIE to expose the bottom 426 of the vias 420 (Figure 33). A layer of thermal oxide is oxidized for isolation of bottom silicon surface (Figure 34), with openings provided in the oxide for forming contacts to the vias and for separate contact to the silicon wafer. Aluminum is then sputtered, patterned and sintered to form back side contacts 428, 429 to the poly silicon via 420 and bottom electrode (Figure 35).

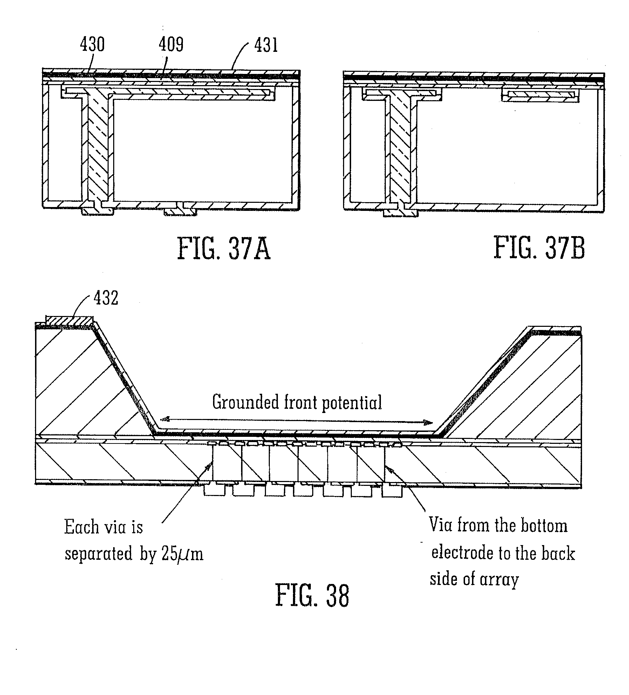

Turning now to Figure 36, it may be seen that the silicon nitride 410 and silicon oxide 409 layers of the top surface of the top silicon wafer are patterned and etched by RIE. The top silicon wafer itself 408 is etched away over the array areas by TMAH with etch stop on silicon oxide. Hence, the silicon oxide and silicon nitride on the lower surface of the top wafer, which both consitute part of the membrane stack, are finally exposed. As shown in Figure 37, a thin uniform metal layer 430 is sputtered on top of the silicon oxide 409, which served as an etch stop during the TMAH etch of the top silicon. This membrane stack metal layer could typically consist of a single layer of aluminum, titanium or tungsten or even combinations of two or more single layer metals. The membrane stack is finalized by an isolating, uniform layer of Plasma-Enhanced Chemical Vapour Deposited (PECVD) 431 passivation layer, typically silicon nitride, which is deposited on top of the metal layer 430.

The final stage (Figure 38) is for the PECVD passivation layer to be opened towards the membrane stack metal at the edge of the chip. Gold 432 is deposited for electrical contacting the membrane stack metal, see Figure 38 We now discuss the backing layer 8 (see Figure 1). To provide the necessary resolution, when the embodiment operates at ultrasound frequencies of 20-50 MHz; the layer 2 is a 20 micron thick micro-machined silicon structure.

As discussed above, beneath CMUT layer 2 is an acoustic layer 4 which serves to provide acoustic isolation of the transducers from the remainder of the device. Since the top layer of the device is almost pure silicon, this layer is provided to prevent the propagation of surface waves. A surface wave is a wave that propagates across the surface of the transducer. If a surface waves were allowed to propagate then they would destroy the operation of the device, at least within a certain range of angles. (In prior art devices, isolation trenches are provided to reduce propagation of waves, but these are not employed in the present embodiment.) The acoustic layer 4 is formed of epoxy resin and is 100 microns in thickness.

The final layer, which will now be discussed in detail, is a further acoustic damping layer 8 which prevents bulk waves from propagating. Such layers are conventional in conventional transducers based on piezoelectric materials. However, the use of two acoustic layers (4 and 8) is original in this design. In conventional piezoelectric ultrasound devices the transducer part is much thicker and there is no sandwich of Silicon between two damping layers and so the single layer of damping layer at the base of the structure (i.e. layer 8) was sufficient to damp the surface waves and bulk waves. However, this has been found to be ineffective especially for the surface waves, when there are Silicon layers between it and the transducer, as in the described embodiment.

The prior art backing layer of Figure 39 corresponds to layer 8 of Figure 1. Its bottom free surface is provided with a "corrugated" surface comprising regular rectangular grooves one quarter of a (specific) wavelength in depth.

A plane longitudinal wave is shown propagating towards the corrugated surface. The grooves have the same width as the distance between the grooves, *d,* and the groove height is *h*. At the dotted line, right above the bottom of the grooves, there, as a first approximation, will be reflected waves with uniform amplitudes along the line, but with phase differences of 2*h*2π/λ between regions with and without grooves. Here λ, is the wavelength of the wave. At a frequency where 4*h* = λ the phase difference is π and the amplitude of the specular reflection, the wave reflected as it would have been from a plane bottom surface, is zero. Instead the wave is converted into longitudinal and shear waves with *k*-vectors in the transverse direction of multiples of +/ - 2π/(2*d*).

However, this conversion will only be effective over a rather narrow band in frequency. The embodiment of the invention which will now be described is able to cover a larger band and uses structures that effectively add several such scattering periodicities with different effective heights *h*.

To make several such scattering structures work independently such that each of them makes a null in the specular wave reflection coefficient at its designed frequency, it is necessary to arrange them such that they add 2*hᵢ* propagation length to signals reflected from half of the total area of any of the possible types of added propagation lengths due to the other propagation delays used. This balance in propagation delays should preferably be maintained both globally, over the complete structure, but also locally, for smaller areas everywhere in the structure.

The embodiment illustrated in Figure 40 is an example of such a structure which is capable of doing this. It comprises etched squares of different sizes, where the squares of each size are organized as on a checker board. The figure is a contour plot of the heights for a part of the interwoven checker board patterns. The scales along the axes are in the 1 to 1.5 mm range, and the height in microns.

To take the general case (not limited to the Figure 40 embodiment), assume that the "black" checker board squares are etched down a certain height *hᵢ* for the *i-*th checker board. To accommodate three heights in the balanced way described above we must scale the size of the squares in the checkerboards such that there is a linear factor of at least two in size between them (two to an integer power). Four squares of the smaller pattern should be placed in one of the next larger squares and so on. Larger squares should give cancellation at lower frequencies through choice of the height difference.

The illustrated embodiment uses such a structure with three interwoven checker boards. In Figure 40, slightly more than four by four of the larger squares (two by two of the largest period) is shown

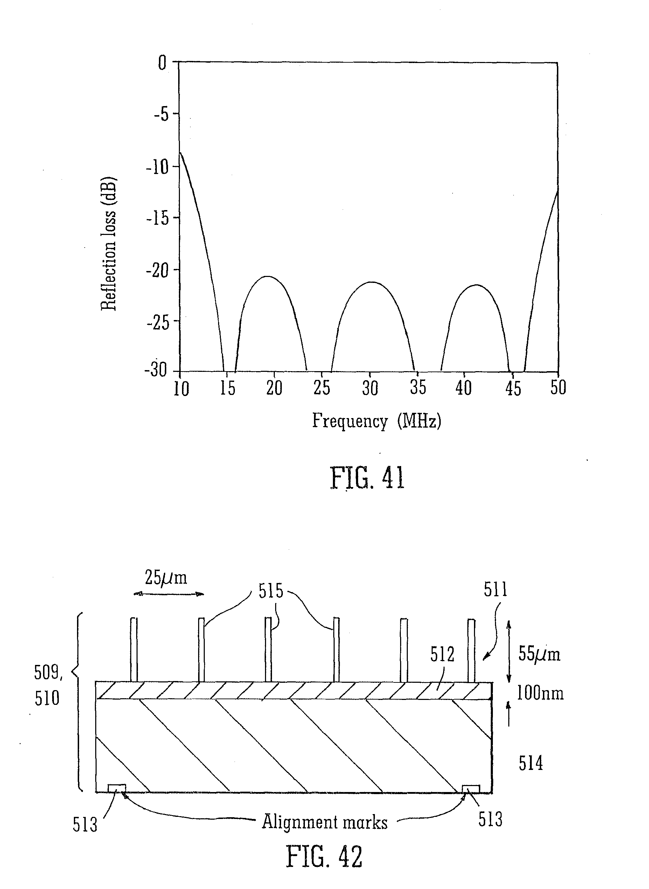

A plot of an obtained specular reflection coefficient versus frequency for the embodiment is shown in Fig. 41. The heights are chosen to give cancellation of the reflection at 15.2 MHz, 24.7 MHz, and 36.1 MHz. The cancellation at about 46 MHz is due to a 1.5 λ delay difference for the 15.2 MHz structure. It is therefore less locally balanced than it could have been at this frequency.

In an alternative embodiment one of the checkerboard patterns in this structure is scaled in dimension such that the factor of two rule mentioned above is broken. In this case, the required balance on a macroscopic scale may still be maintained, such that the result in figure 41 is almost unchanged. But careful investigation of what happens with reflection from smaller areas will show that the efficiency is reduced.

In another embodiment (not illustrated) several groove structures are overlaid on top of each other such that they are all active at the same time, and balanced as described above. Different directions are used for grooves with different depth and also different width which are designed to make them active at desired frequencies. Three structures of grooves could have grove directions that differ by 45 degrees and 90 degrees internally.

Another embodiment (not illustrated) has a basic pattern of two triangles which together forms a square or a rectangle. A structure which forms a balanced depth pattern combined with this could be the structure which is obtained if the square or rectangle is divided into triangles by the other of the two possible diagonals.

To include more patterns one could repeat the same structure with rectangles where the dimensions in the plane are scaled up or down a factor of two. As discussed above, beneath CMUT layer 2 (see Figure 1) is an acoustic damping layer 4 which serves to provide acoustic isolation of the transducers from the remainder of the device. The fabrication process for the damping layer 4 will now be described in further detail with reference to the remaining figures.

Turning first to Figure 42, the process starts with two similar box wafers 509, 510 with device layer 511 thicknesses of 55 microns and an oxide layer 512 thickness of 100nm. On these wafers we define alignment marks 513 on the back sides 514 (the sides without device layers), and then the device layers 511 on the front sides of both wafers are patterned with photo resist and etched using Deep Reactive Ion Etching, DRIE, to form poles of silicon 515 with a diameter of 5 microns in a rectangular pattern with a pitch in both directions of 25 microns. As may be seen, the etching goes all the way through the device layers 11, and stops on the oxide layers 512.

The next stage is for the wafers 509 and 510 to be doped and heat treated such that high conductivity is obtained in the pole material.

As may be seen from Figure 43, the next stage is for a mixture of fluid epoxy and tungsten powder 516 to be carefully spread out on top of the wafers (with the side with poles pointing upwards) so that the poles 515 are surrounded by this material. Under vacuum the wafers 509, 510 are given a suitable heat treatment to allow the epoxy to flow easily and degas. It also allows the tungsten powder to sink to the bottom of the epoxy layer, close to the silicon surface, and then to harden. After the epoxy has solidified, the surfaces with epoxy on the wafers 509, 510 are ground down and carefully polished until the top surfaces of the poles 515 are free. Then, as may be seen in plan view in Figure 44, on one of the wafers electrically conductive metal lines 17 are fabricated using metal deposition (damping or sputtering), photo resist patterning and etching.

The epoxy layers of the two wafers 9, 10 are aligned, using the alignment marks 13 on the back side of the wafers, such that the poles in one of the wafers are positioned in the middle of four poles on the other wafer. Once they are properly aligned, the wafers are glued together using anisotropically conducting glue The metal lines 517 on one of the wafers will now make electrical contact between the conducting poles 15 in the two wafers, as shown in Figure 45. (Note that this figure shows the completed damping layer 4 after the back layers 514, etc. have been removed, see below.)

The next step is then to etch away one of the two back layers 514 (which have acted as handles) down to the oxide layer 512 using an appropriate etch. The regions where the poles are situated will then be visible through the oxide 512 because the oxide is thin (100 nm). The oxide is then patterned with photo resist and etched away at least over the poles, and optionally over the whole surface. A metal film (not shown) is then formed on the surface, and patterned using etching and photo resist making contacts suitable for connection to the bottom surface of the CMUT wafer 2. (Alternatively it could be the bottom surface of one or more electronics wafers already connected to the CMUT wafer). Once again anisotropically conducting glue is used to connect the damping layer 4 to the CMUT layer 2.

With this done, the combined structure may then be carried by a handle layer (not shown) on the opposite side of the CMUT layer 2. This allows the remaining handle layer 514 of the second wafer 510 to be etched away and the surface prepared for connection using anisotropically conducting glue to other electronics wafers (specifically layer 5) as described above.

## Claims

1. An acoustic backing layer for use in an ultrasound transducer, the layer being arranged to scatter ultrasound waves of a plurality of distinct frequencies, wherein the layer comprises a plurality of scattering structures that act independently of each other such that each creates a null in the specular wave reflection coefficient at a given frequency.

2. An acoustic backing layer as claimed in claim 1, wherein the scattering structures are arranged such that they add 2*hᵢ* propagation length to signals reflected from half of the total area of any of the possible types of added propagation lengths due to the other propagation delays used.

3. An acoustic layer as claimed in claim 1 or 2, wherein the scattering structures comprise etched squares of different sizes.

4. An acoustic layer as claimed in any claim 3, wherein the squares of each size are organized as in a checker-board pattern, with the squares corresponding to one colour on a checker board being etched down a certain height *hᵢ* for the *i*-th checker board.

5. An acoustic layer as claimed in claim 4, wherein the size of the squares in the checker boards may be scaled such that there is a linear factor of at least two in size between them

6. An acoustic backing layer as claimed in claim 1 or 2, wherein the structures comprise parallel grooves which are overlaid on top of each other.

7. An acoustic backing layer as claimed in claim 6, wherein the grooves of the separate structures have groove directions that differ by 45 degrees and/or 90 degrees internally.

8. An acoustic backing layer as claimed in claim 1 or 2, wherein the structures comprise sets of periodic grooves in the same direction with different depths and widths, which are overlaid on one another such that the total depth in a given point is that which follows from the sum of all overlaid groove structures.

9. An acoustic backing layer as claimed in claim 8, wherein there is an integer relationship between the periods of the different groove structures.

10. An acoustic backing layer as claimed in claim 1 or 2, wherein the structures comprise a pattern of two triangles which together form a square or a rectangle.

11. An acoustic layer as claimed in any preceding claim formed of epoxy and tungsten.

12. An acoustic layer as claimed in any preceding claim, wherein the structures comprise recesses in the surfaces that are equal in depth to one quarter of the wavelength of the waves that they attenuate.

13. An ultrasound transducer comprising a CMUT array, signal processing layers and a backing layer as claimed in any preceding claim.

14. An ultrasound transducer as claimed in claim 13, further comprising an acoustic layer between the CMUT array and the signal processing layers.
